# EUROPEAN PATENT APPLICATION

(11) **EP 1 628 310 A1**
(43) Date of publication of application: **22.02.2006**
(21) Application number: 04734901.4
(22) Date of filing: 26.05.2004
(51) Int. Cl.: H01B 5/14, H01B 13/00, B32B 7/02

(54) **LIGHT-TRANSMITTING SUBSTRATE WITH TRANSPARENT ELECTROCONDUCTIVE FILM**

(30) Priority: 26.05.2003 JP 2003147265
(71) Applicant: NIPPON SODA CO., LTD., Chiyoda-ku, Tokyo 100-8165 (JP)
(72) Inventor: KANDA, Hiroyuki, c/o Nippon Soda Co., Ltd., Tokyo 1008165 (JP); SETA, Yasuhiro, c/o Chiba Plant, Ichihara-shi, Chiba 2908530 (JP); OOASHI, Tatsuya, c/o Chiba Plant, Ichihara-shi, Chiba28 08530 (JP)
(74) Representative: Wibbelmann, Jobst
(86) International application number: PCT/JP2004/007543
(87) International publication number: WO 2004/105055

(57) **Abstract**

An object of the present invention is to provide a sufficiently high-transparent light transmitting substrate with a transparent conductive film, which is a light transmitting substrate with a transparent conductive film, comprising a light transmitting substrate and a continuous transparent conductive film having a thickness of 12 to 2 nm formed on the light transmitting substrate, and is preferably a light transmitting substrate with a transparent conductive film, wherein the transparent conductive film is made of an aggregate of columnar single crystals, the transparent conductive film has a maximum surface roughness within a range from 1 to 20 nm, the transparent conductive film has an average surface roughness within a range from 0.1 to 10 nm, the transparent conductive film is a thin film made of a tin-doped indium oxide, tin atoms are uniformly distributed in the thin film made of the tin-doped indium oxide, a transmittance to light having a wavelength of 400 nm is 88% or more, a transmittance to light having a wavelength of 350 nm is 85% or more, and a whole light transmittance is 90% or more.

## Description

### TECHNICAL FIELD

The present invention relates to a high-transparent light transmitting substrate with a conductive film.

### PRIOR ART

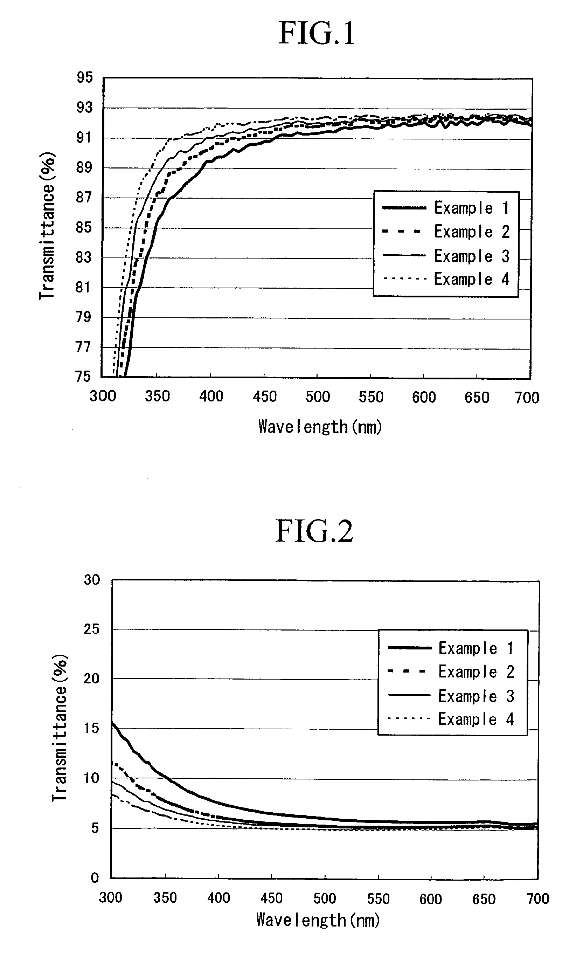

Japanese Unexamined Patent Application, First Publication No. Hei 7-242442 describes, as a light transmitting substrate with a thin transparent conductive film, a light transmitting substrate wherein a tin-doped indium oxide (ITO) film has a thickness of 23 nm and a light transmittance at 550 nm is 95.1% (apparent from Fig. 1, a light transmittance at 400 nm is considered to be 87.6%), and Japanese Unexamined Patent Application, First Publication No. Hei 7-242443 describes a light transmitting substrate wherein a ITO film has a thickness of 20 nm and a light transmittance at 400 nm is 86.8% and a light transmittance at 500 nm is 92.2%. It has been considered that, when the conductive film of the light transmitting substrate with a transparent conductive film is an ultrathin film at the nm level, a continuous film is not formed.

### DISCLOSURE OF THE INVENTION

Although a high-transparent light transmitting substrate with a transparent conductive film is required, the ITO film described in the publications described above is not sufficiently high-transparent, necessarily, within a visible range (380 to 780 nm).

An object of the present invention is to provide a sufficiently high-transparent light transmitting substrate with a transparent conductive film. The present inventors have intensively studied so as to achieve the above problems and succeeded in the formation of an ultrathin continuous film at the nm level as a conductive film of light transmitting substrate with a transparent conductive film, and thus the present invention has been completed.

That is, the present invention is directed to the followings:
(1) A light transmitting substrate with a transparent conductive film, comprising a light transmitting substrate and a continuous transparent conductive film having a thickness of 12 to 2 nm formed on the light transmitting substrate;
(2) The light transmitting substrate with a transparent conductive film according to (1), wherein the transparent conductive film is made of an aggregate of columnar single crystals;
(3) The light transmitting substrate with a transparent conductive film according to (1) or (2), wherein the transparent conductive film has a maximum surface roughness within a range from 1 to 20 nm;
(4) The light transmitting substrate with a transparent conductive film according to any one of (1) to (3), wherein the transparent conductive film has an average surface roughness within a range from 0.1 to 10 nm;
(5) The light transmitting substrate with a transparent conductive film according to any one of (1) to (4), wherein the transparent conductive film is a thin film made of a tin-doped indium oxide;
(6) The light transmitting substrate with a transparent conductive film according to (5), wherein tin atoms are uniformly distributed in the thin film made of the tin-doped indium oxide;
(7) The light transmitting substrate with a transparent conductive film according to any one of (1) to (6), wherein the transparent conductive film is a conductive film formed on the substrate through a spray pyrolysis deposition method or a pyrosol method;
(8) The light transmitting substrate with a transparent conductive film according to (7), wherein the conductive film is formed at a temperature on the substrate within a range from 400 to 750°C;
(9) The light transmitting substrate with a transparent conductive film according to any one of (1) to (8), wherein a transmittance to light having a wavelength of 400 nm is 88% or more;
(10) The light transmitting substrate with a transparent conductive film according to any one of (1) to (9), wherein a transmittance to light having a wavelength of 350 nm is 85% or more; and
(11) The light transmitting substrate with a transparent conductive film according to any one of claims (1) to (10), wherein a whole light transmittance is 90% or more.

In the present invention, the light transmitting substrate is preferably a glass substrate which is easily available and is excellent in light transmitting properties and other physical properties, or is preferably a resin substrate. The glass substrate can be roughly classified into alkali glass and non-alkali glass. The alkali glass is cheap and easily available and is therefore advantageous in view of cost. However, the alkali glass has such a drawback that it contains about 13 to 14% of an alkali metal oxide and therefore requires a measure to prevent contamination with the alkali metal and is also inferior in heat resistance. On the other hand, the non-alkali glass is preferable because it is free from care about contamination with the alkali metal and has heat resistance.

As the alkali glass, for example, there is known sodalime glass with the composition consisting of SiO₂: 72% by weight, Al₂O₃: 2% by weight, CaO: 8% by weight, MgO: 4% by weight and Na₂O: 13.5% by weight. As the non-alkali glass, for example, there are known borosicilic acid (7059) glass with the composition consisting of SiO₂: 49% by weight, Al₂O₃: 10% by weight, B₂O₃: 15% by weight and BaO: 25% by weight, borosicilic acid (AN) glass with the composition consisting of SiO₂: 53% by weight, Al₂O₃: 11% by weight, B₂O₃: 11% by weight, CaO: 2% by weight, MgO: 2% by weight, BaO: 15% by weight and ZnO: 6% by weight, borosicilic acid (NA-40) glass with the composition consisting of SiO₂: 54% by weight, Al₂O₃: 14% by weight, B₂O₃: 15% by weight and MgO: 25% by weight, borosicilic acid (BLC) glass and non-alkali (OA-10) glass.

The surface roughness of substrates such as these glasses is preferably an average surface roughness Ra ≤ 10 nm and a maximum surface roughness Rmax ≤ 50 nm, and also the substrate may be polished. In case of the substrate using the alkali glass, the surface roughness is preferably an average surface roughness Ra ≤ 10 nm and a maximum surface roughness Rmax ≤ 50 nm. In case of the substrate using the non-alkali glass, the surface roughness is preferably an average surface roughness Ra ≤ 5 and a maximum surface roughness Rmax ≤ 20 nm. The lower limited is not specifically restricted and is usually an average surface roughness Ra ≥ 0.1 nm and a maximum surface roughness Rmax ≥ 0.5 nm. The surface roughness of the glass substrate may be controlled within the above range by mirror polishing using diamond or cerium oxide.

Specific examples of the substrate made of a resin include film, sheet or plate made of polyesters such as polycarbonate, polyethylene terephthalate and polyallylate, polyethersulfone-based resins, amorphous polyolefins, polystyrenes and acrylic resins. In view of transparency and moldability, a substrate made of a polyolefin-based transparent thermosetting resin is preferably used, and a substrate made of a polyolefin-based copolymer prepared by polymerizing a composition containing a polyfunctional monomer having two or more unsaturated groups is more preferably used.

Specific examples of the polyfunctional monomer having two or more unsaturated groups include (i) di-, tri- and tetra-(meth)acrylates of polyhydric alcohol, such as ethylene glycol di(meth)acrylate, diethylene glycol di(meth)acrylate, triethylene glycol di(meth)acrylate, glycerol di(meth)acrylate, glycerol tri(meth)acrylate, trimethylolpropane di(meth)acrylate, trimethylolpropane tri(meth)acrylate, pentaerythritol di(meth)acrylate, pentaerythritol tri(meth)acrylate and pentaerythritol tetra(meth)acrylate; (ii) aromatic polyfunctional monomers such as p-divinylbenzene and o-divinylbenzene; (iii) esters such as vinyl (meth)acrylate and allyl (meth)acrylate; (iv) dienes such as butadiene, hexadiene and pentadiene; (v) monomers comprising a phosphazene skeleton having a polymerized polyfunctional group introduced therein using dichlorophosphazene as a raw material, and (vi) polyfunctional monomers comprising a heteroatom cyclic skeleton such as triallyl isocyanurate.

The transparent thermosetting resin preferably contains various ultraviolet absorbers, antioxidants and antistatic agents in view of light resistance, oxidation deterioration resistance and antistatic properties. When the transparent thermosetting resin is a polyolefin-based copolymer, the polyolefin-based copolymer is preferably derived from a monomer having ultraviolet absorptivity or antioxidation properties. Preferable examples of the monomer include benzophenone-based ultraviolet absorber having an unsaturated double bond, phenylbenzoate-based ultraviolet absorber having an unsaturated double bond, and (meth)acrylic acid monomer having a hindered amino group as a substituent. The content of these monomers is preferably within a range from 0.5 to 20% by weight based on the total amount of the monomer to be used to obtain the objective polyolefin-based copolymer.

Regarding the surface state of the resin substrate to be used, an average squared value of surface roughness is preferably 30 nm or less and the number of projections in size of 60 nm or more, which exist in a region of 500 µm squares on the flat surface, is preferably 20 or less. The term "average squared value of surface roughness" used herein with respect to the flat surface is an average squared value of a difference from an average of the height of surface irregularity and means the degree of surface irregularity. The term "number of projections in size of 60 nm or more which exist in a region of 500 µm squares on the flat surface" means an average of the number of projections in size of 60 nm or more which exist in each of 10 regions of 500 µm squares set optionally on the flat surface. The height and number of projections in each region can be determined by an electron microscopy or an atomic force microscope.

The resin substrate may be obtained by any polymerization and molding method as far as it has the above-described flat surface. The thickness can be appropriately selected according to the objective purposes. When the transparent thermosetting resin substrate is made of the polyolefin-based copolymer, the thickness is preferably from 0.1 to 1.5 mm, and more preferably from 0.1 to 1.0 mm, in view of mechanical characteristics.

If necessary, an inorganic oxide film can be formed between the light transmitting substrate and the transparent conductive film so as to prevent an alkali component from penetrating into the transparent conductive film. Specific examples of the inorganic oxide film include film made of silicon oxide (SiOₓ), aluminum oxide (Al₂Oₓ), titanium oxide (TiOₓ), zirconium oxide (ZrOₓ), yttrium oxide (Y₂Oₓ) , ytterbium oxide (Yb₂Oₓ), magnesium oxide (MgOₓ), tantalum oxide (Ta₂Oₓ), cerium oxide (CeOₓ) or hafnium oxide (HfOₓ), polysilane film made of an organic polysilane compound, MgF₂ film, CaF₂ film, and film made of a complex oxide of SiOₓ and TiOx.

The thickness of the inorganic oxide film can appropriately vary according to the material, but is within a range from about 2 to 20 nm. When the thickness of the film is too thin, it is impossible to prevent the alkali component from penetrating. On the other hand, when the thickness of the film is too thick, light transmitting properties deteriorate.

The smoothness of the surface of the inorganic oxide film is preferably excellent and the same as that of the flat surface in the substrate as a backing of the inorganic oxide film. The inorganic oxide film having such smoothness can be formed by sputtering methods such as direct current method, magnetron method and high frequency discharge method, vacuum deposition method, ion plating method, plasma CVD method, dipping method, spray pyrolysis deposition method and pyrosol method. Even in case of forming the inorganic oxide film by any method, the substrate temperature upon film formation is preferably the temperature at which the substrate substantially causes no thermal deformation.

Examples of the transparent conductive film include films made of tin-doped indium oxide (ITO), zinc-doped indium oxide (IZO), aluminum-doped zinc oxide, FTO, ATO, ZnO, SnO₂ and In₂O₃, and an ITO film is preferable. In case of increasing the light transmittance, the thinner the transparent conductive film, the better. Since it is necessary to form a continuous film having no island structure, the thickness of the film is from 12 to 2 nm, and preferably from 10 to 2 nm. The thickness of the film is preferably from 9 to 2 nm so as to increase the light transmittance, and is preferably from 8 to 2 nm so as to further increase the light transmittance. Regarding the light transmittance of the light transmitting substrate with a transparent conductive film of the present invention, the light transmittance to light having a wavelength of 400 nm is preferably 88% or more, more preferably 90% or more, and the whole light transmittance is preferably 90% or more, more preferably 92% or more, and still more preferably 93% or more. In the light transmitting substrate with a transparent conductive film, the light transmittance to light having a shorter wavelength of 350 nm is preferably 85% or more. The larger the light transmittance, the better.

When the ITO film is used as the transparent conductive film, it usually contains In₂O₃ and SnO₂ in a stoichiometrical ratio, but the oxygen content may slightly deviates from the ratio. In case of InO_{X}·SnO_{Y}, X is preferably within a range from 1.0 to 2.0 and Y is preferably within a range from 1.6 to 2.4. Relative to In₂O₃, the content of SnO₂ is preferably within a range from 0.05 to 40% by weight, more preferably from 1 to 20% by weight, and still more preferably from 5 to 12% by weight. When the content of SnO₂ increases, thermal stability increases.

The method for producing a transparent conductive film is not specifically limited as far as it is a method of forming a thin film on the substrate, and specific examples thereof include sputtering method, electron beam method, ion plating method, screen printing method or chemical vapor deposition method (CVD method), spray pyrolysis deposition method and pyrosol method. Among these methods, a spray pyrolysis deposition method and a pyrosol method are particularly preferable.

More specifically, according to the sputtering method, the transparent conductive film can be formed by using, as a target, metal (for example, indium or zinc) and a mixture of metal (for example, tin, fluorine, fluorine compound or aluminum) to be doped and an oxygen gas, or those obtained by sintering metal oxide (for example, indium oxide or zinc oxide). According to the electron beam method or ion plating method, the transparent conductive film can be formed by using, as a vaporized material, metal (for example, indium or zinc) and a mixture of metal (for example, tin, fluorine, fluorine compound or aluminum) to be doped and an oxygen gas, or those obtained by sintering metal oxide (for example, indium oxide or zinc oxide).

In case of forming a conductive film made of ITO using the sputtering method, the film is preferably formed by a DC sputtering method using a target composed of In₂O₃ doped with SnO₂, or a RF sputtering method.

The sputtering gas is not specifically limited and an inert gas such as Ar, He, Ne, Kr or Xe gas or a gas mixture thereof may be used. These gases may contain 20% or less of O₂. In case of sputtering of the sputtering gas, the pressure may be usually from about 0.1 to 20 Pa.

The substrate temperature upon film formation is preferably within a range from 150 to 500°C, and particularly preferably from 200 to 400°C.

After forming the conductive film made of ITO, a heat treatment can be conducted. The temperature of the heat treatment is preferably within a range from 100 to 550°C, and more preferably from 150 to 300°C, and the treatment time is preferably within a range from 0.1 to 3 hours, and more preferably from 0.3 to 1 hours. The treatment atmosphere is preferably air, nitrogen, oxygen or hydrogen-added nitrogen atmosphere, or organic solvent-added air or nitrogen atmosphere.

The indium compound used in the CVD method, spray pyrolysis deposition method or pyrosol method is preferably a substance which is thermally decomposed to give an indium oxide, and specific examples thereof include indium trisacetylacetonate (In(CH₃COCHCOCH₃)₃), indium trisbenzoylmethanate (In(C₆H₅COCHCOC₆H₅)₃), indium trichloride (InCl₃), indium nitrate (In(NO₃)₃) and indium triisopropoxide (In(OPr-i)₃). Among these indium compounds, indium trisacetylacetonate is preferable.

As the tin compound, there can be preferably used those which are thermally decomposed to give a stannic oxide, and specific examples thereof include stannic chloride, dimethyltin dichloride, dibutyltin dichloride, tetrabutyltin, stannous octoate (Sn(OCOC₇H₁₅)₂), dibutyltin maleate, dibutyltin acetate and dibutyltin bisacetylacetonate.

It is also preferred to form an ITO film by adding as a third component, in addition to the indium compound and the tin compound, Group 2 elements of the Periodic Table such as Mg, Ca, Sr and Ba, Group 3 elements such as Sc and Y, lanthanoids such as La, Ce, Nd, Sm and Gd, Group 4 elements such as Ti, Zr and Hf, Group 5 elements such as V, Nb and Ta, Group 6 elements such as Cr, Mo and W, Group 7 elements such as Mn, Group 9 elements such as Co, Group 10 elements such as Ni, Pd and Pt, Group 11 elements such as Cu and Ag, Group 12 elements such as Zn and Cd, Group 13 elements such as B, Al and Ga, Group 14 elements such as Si, Ge and Pb, Group 15 elements such as P, As and Sb, Group 16 elements such as Se and Te alone or compounds thereof.

The content of these elements is preferably from about 0.05 to 20 atomic % based on indium and varies according to the kind of the additional element, and the element and the amount suited for the objective resistance value can be appropriately selected.

To form an ITO film on a glass substrate by the pyrosol method or spray pyrolysis deposition method, there can be employed a method comprising dissolving the above-described indium compound and tin compound in organic solvents, for example, alcohols such as methanol and ethanol and ketones such as acetone, methyl butyl ketone and acetylacetone to give a solution mixture, dispersing the solution mixture in a carrier gas after forming into fine particles, and contacting the solution mixture with a glass substrate heated previously to a temperature within a range from 400 to 750°C, and preferably from 400 to 550°C under normal pressure. The solution mixture can be formed into fine particles by an ultrasonic atomization method or a spray method, and preferably an ultrasonic atomization method capable of stably generating fine particles having a uniform particle size. The carrier gas to be used is an oxidized gas, and usually an air.

When the pyrosol method is employed, by contacting fine particles of the solution mixture with the heated glass substrate, a crystalline nucleus with the composition of the ITO film is produced on the glass substrate and is contacted with adjacent nucleus with the growth of the nucleus. Since contacted nuclei are mutually restricted, the nucleus mainly grows in the direction perpendicular to the substrate surface, and thus an ITO film as a composite of oriented columnar single crystals is easily obtained and the resulting ITO film is excellent in etching properties. When the ITO film is formed by the pyrosol method, since tin atoms are uniformly distributed in the film from the substrate to the film surface, it is not necessary to polish the resulting film so as to make it uniform. In this case, the term "uniform" means that tin atoms are not segregated on the film surface and the value of the film surface is not two times larger than an average value in the film in an atomic ratio tin/indium.

The transparent conductive film is preferably a crystalline conductive film. The structure of the film is not specifically limited and may be a structure wherein lumpy crystals are laminated, but is preferably an aggregate of columnar single crystals. The transparent conductive film preferably has a grain size within a range from 20 to 100 nm. The shape of the crystallite is not specifically limited and is preferably spherical or rotating ellipsoidal, and preferably include less projections and edges. The shape and size of the crystallite can be evaluated by observing the surface using a transmission electron microscopy (TEM). In the transparent conductive film of the present invention, the maximum surface roughness Rmax is preferably within a range from 1 to 20 nm, more preferably from 1 to 15 nm, and the average surface roughness Ra is preferably within a range from 0.1 to 10 nm, more preferably from 0.1 to 1 nm.

If necessary, the conductive film thus formed on the substrate may be further subjected to UV ozone irradiation, or irradiation with ions such as oxygen, nitrogen and argon ions. UV ozone irradiation is conducted under the conditions of a dominant wavelength of a light source of 2537 angstroms and 1849 angstroms, an amount of an oxygen gas to be introduced into an irradiation tank of 10 liters/min., a substrate temperature of 10 to 30°C and an irradiation time of 10 minutes to 5 hours. Ion irradiation is conducted under the conditions of a pressure in an irradiation tank of 10⁻⁶ to 10⁻¹ Pa, an irradiation drive voltage of 10 to 1000 V, and an irradiation time of 10 seconds to 1 hour. A conductive film having desired surface irregularity may be subjected to the above-described UV ozone irradiation and ion irradiation. When subjected to the UV ozone irradiation or ion irradiation, the surface of the conductive film can be cleaned without causing damage of the substrate.

### BRIEF DESCRIPTION OF THE DRAWINGS

Fig. 1 shows spectral characteristics (light transmittance) of ITO glasses produced in Examples 1 to 4.
Fig. 2 shows spectral characteristics (reflectance) of ITO glasses produced in Examples 1 to 4.
Fig. 3 is a surface photograph obtained by an atomic force microscope of an ITO glass produced in Example 3.
Fig. 4 shows measurement results of the indium content and the tin content in the depth direction of an ITO film due to ESCA of ITO glasses obtained by Examples 5 to 6.

### BEST MODE FOR CARRYING OUT THE INVENTION

The present invention will now be described in detail by way of examples, but the scope of the present invention is not limited to the following examples.

### Example 1

An ITO film was formed on a glass substrate by a pyrosol method. That is, a borosicilic acid (BLC) glass polished substrate (260 × 220 × 0.4 mm) precoated with a SiO₂ film (thickness: 10 nm) was placed in a conveyer furnace heated to 500°C through a belt conveyor and an acetylacetone solution of stannic chloride-indium acetylacetonate containing 12 atomic % of tin atoms was brown into the conveyer furnace using an air as a carrier gas after forming into fog drip, thereby to contact with the surface of the glass substrate and to cause thermal decomposition, and thus an ITO film having a thickness of 12 nm was formed. The resulting ITO film had a surface resistance value of 1.7 KΩ/ D. The surface of the film was observed by an atomic force microscope (AFM). As a result, an average surface roughness Ra was 0.7 nm and a maximum surface roughness Rmax was 12 nm. A light transmittance of spectral characteristics of the resulting ITO glass is shown in Fig. 1 and a reflectance is shown in Fig. 2.

### Example 2

In the same manner as in Example 1, except that the belt conveyor speed and the amount of the chemical to be atomized were adjusted, an ITO film having a thickness of 10 nm was formed.

The analytical results of the resulting ITO glass are shown in Table 1, a light transmittance of spectral characteristics are shown in Fig. 1, and a reflectance is shown in Fig. 2.

### Example 3

An ITO film was formed on a glass substrate by a pyrosol method. That is, a borosicilic acid (BLC) glass polished substrate (260 × 220 × 0.4 mm) precoated with a SiO₂ film (thickness: 10 nm) was placed in a conveyer furnace heated to 500°C through a belt conveyor and an acetylacetone solution of stannic chloride-indium acetylacetonate containing 12 atomic % of tin atoms was brown into the conveyer furnace using an air as a carrier gas after forming into fog drip, thereby to contact with the surface of the glass substrate and to cause thermal decomposition, and thus an LTO film having a thickness of 8 nm was formed. The surface of the film was observed by AFM. As a result, an average surface roughness Ra was 0.8 nm and a maximum surface roughness Rmax was 13 nm. A light transmittance of spectral characteristics of the resulting ITO glass is shown in Fig. 1 and a reflectance is shown in Fig. 2.

### Example 4

In the same manner as in Example 3, except that the belt conveyor speed and the amount of the chemical to be atomized were adjusted, an ITO film having a thickness of 6 nm was formed.

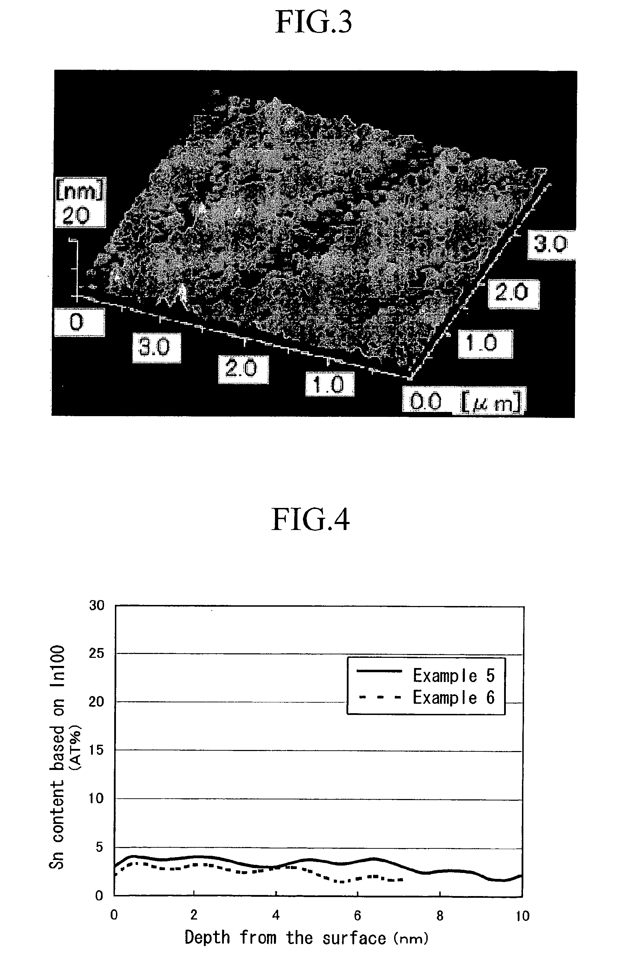

The analytical results of the resulting ITO glass are shown in Table 1, a light transmittance of spectral characteristics are shown in Fig. 1, a reflectance is shown in Fig. 2, and a surface photograph obtained by AFM is shown in Fig. 3.

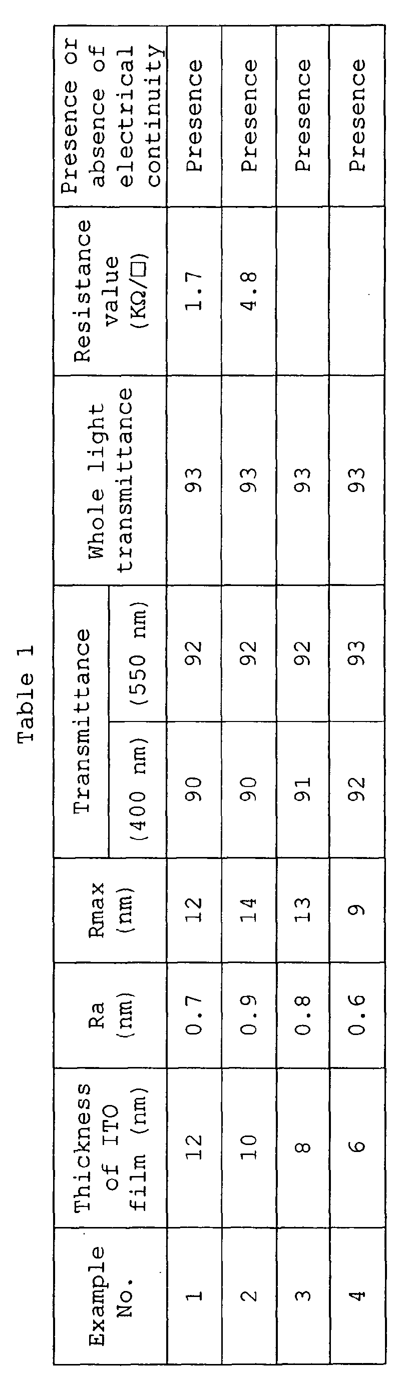

ITO film was not peeled off and the ITO glasses obtained by Examples 1 to 4 were not corroded with an alkali even when washed.

### Example 5

In the same manner as in Example 1, except that an acetylacetone solution of stannic chloride-indium acetylacetonate containing 5 atomic % of tin atoms was used as a chemical and the belt conveyor speed and the amount of the chemical to be atomized were adjusted, an ITO film having a thickness of 10 nm was formed.

The resulting ITO glass had a whole light transmittance of 93%. The composition of metal atoms in the film was measured by ESCA. As a result, tin atoms uniformly existed in the film from the surface to the substrate without causing segregation. The measurement results are shown in Fig. 4.

### Example 6

In the same manner as in Example 5, except that the belt conveyor speed and the amount of the chemical to be atomized were adjusted, an ITO film having a thickness of 8 nm was formed. The resulting ITO glass had a whole light transmittance of 93%. The composition of metal atoms in the film was measured by ESCA. As a result, tin atoms uniformly existed in the film from the surface to the substrate without causing segregation. The measurement results are shown in Fig. 4.

### INDUSTRIAL APPLICABILITY

The light transmitting substrate with a transparent conductive film of the present invention has high transparency and can save light quantity and energy of the device, and is also suited for use as electrodes of liquid crystal displays (LCD), liquid crystal dimmers and LCD lens, and thus its industrial utility value is great.

## Claims

1. A light transmitting substrate with a transparent conductive film, comprising a light transmitting substrate and a continuous transparent conductive film having a thickness of 12 to 2 nm formed on the light transmitting substrate.

2. The light transmitting substrate with a transparent conductive film according to claim 1, wherein the transparent conductive film is made of an aggregate of columnar single crystals.

3. The light transmitting substrate with a transparent conductive film according to claim 1 or 2, wherein the transparent conductive film has a maximum surface roughness within a range from 1 to 20 nm.

4. The light transmitting substrate with a transparent conductive film according to any one of claims 1 to 3, wherein the transparent conductive film has an average surface roughness within a range from 0.1 to 10 nm.

5. The light transmitting substrate with a transparent conductive film according to any one of claims 1 to 4, wherein the transparent conductive film is a thin film made of a tin-doped indium oxide.

6. The light transmitting substrate with a transparent conductive film according to claim 5, wherein tin atoms are uniformly distributed in the thin film made of the tin-doped indium oxide.

7. The light transmitting substrate with a transparent conductive film according to any one of claims 1 to 6, wherein the transparent conductive film is a conductive film formed on the substrate through a spray pyrolysis deposition method or a pyrosol method.

8. The light transmitting substrate with a transparent conductive film according to claim 7, wherein the conductive film is formed at a temperature on the substrate within a range from 400 to 750°C.

9. The light transmitting substrate with a transparent conductive film according to any one of claims 1 to 8, wherein a transmittance to light having a wavelength of 400 nm is 88% or more.

10. The light transmitting substrate with a transparent conductive film according to any one of (1) to (9), wherein a transmittance to light having a wavelength of 350 nm is 85% or more.

11. The light transmitting substrate with a transparent conductive film according to any one of claims 1 to 10, wherein a whole light transmittance is 90% or more.
